(19)

Europäisches
Patentamt

European
Patent Office

Office européen
des brevets

(11) **EP 3 024 202 A1**

(12) **EUROPEAN PATENT APPLICATION**
published in accordance with Art. 153(4) EPC

(43) Date of publication:
**25.05.2016 Bulletin 2016/21**

(21) Application number: **13881985.9**

(22) Date of filing: **31.10.2013**

(51) Int Cl.:
**H04M 1/02** (2006.01)

(86) International application number:
**PCT/CN2013/086270**

(87) International publication number:
**WO 2014/166238 (16.10.2014 Gazette 2014/42)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **21.08.2013 CN 201310368801**

(71) Applicant: **ZTE Corporation**
**Shenzhen, Guangdong 518057 (CN)**

(72) Inventor: **WANG, Bing**
**Shenzhen**
**Guangdong 518057 (CN)**

(74) Representative: **Awapatent AB**
**Junkersgatan 1**
**582 35 Linköping (SE)**

(54) **MOBILE TERMINAL AND HEAT DISSIPATION METHOD OF LIQUID METAL OF SAME**

(57)     A mobile terminal and a liquid metal heat dissipation method thereof. The liquid metal heat dissipation method of the mobile terminal includes: when an inner or surface temperature of a mobile terminal exceeds a set temperature, controlling liquid metal pre-positioned in the mobile terminal to flow to a high-temperature area whose temperature exceeds the set temperature to perform a head absorption operation, and controlling the heat-absorbed liquid metal to flow to a non-high-temperature zone lower than the set temperature to perform a heat dissipation operation.

FIG. 7

EP 3 024 202 A1

## Description

Technical Field

The present invention relates to the field of mobile communications, and more particularly, to a mobile terminal and a liquid metal heat dissipation method thereof.

Background of the Invention

Today, the communication technology develops rapidly, and mobile terminal devices, from data cards to functional phones and even to smart phones, have become essential communication tools for people to communicate. Taking the smart phones for example, the clock speed of the existing smart phones is higher and higher, their function configurations are more and more complex, and their power consumption is also growing, so that the mobile phone heating is also very severe, for example, the battery heating is the most common phenomenon, and the battery heating may cause the battery bulge, reduce the battery life, and drives the other mobile phone parts to heat up, so that the system cannot work normally or restart, and severe battery overheating can cause damages such as that the battery explodes and hurts people, which gives us warning. When a mobile phone is in a call or processes large amounts of wireless data services, the working efficiency of the mobile phone's radio frequency components is relatively high, and will produce lots of heat, a lot of heat energy will be transferred to other parts of the mobile phone and causes system to be abnormal; a single-core or multi-core processor with relatively high clock speed will also dissipate a lot of heat when processing a large number of services such as multimedia services, its impact is the same as the above damages, ranging from minor damages such as system abnormalities to major damages such as device damages.

As always, the electronics industry also carries on research about the heat dissipation problem, the laptop uses cooling fans and cooling plates, but the heat dissipation solution for the laptop cannot be implemented in the mobile terminal device due to its features such as small size, portability, and lightweight; a mobile terminal with high-performance and without the heat dissipation problem will be an ideal product to which the heart of everyone belongs, thereby, the user experience can be greatly improved, and the wide development of mobile terminals with high-performance can be promoted.

Summary of the Invention

The embodiment of the present invention provides a mobile terminal and a liquid metal heat dissipation method thereof, to solve the problem in the related art that the heat dissipation efficiency is low and high-temperature areas of a high-performance mobile terminal cannot be quickly and efficiently cooled down.

The embodiment of the present invention provides a liquid metal heat dissipation method of a mobile terminal, comprising:

controlling liquid metal pre-positioned within a mobile terminal to flow to a high-temperature area whose temperature exceeds a set temperature to perform a heat absorption operation when an inner or surface temperature of the mobile terminal exceeds the set temperature, controlling the heat-absorbed liquid metal to flow to a non-high-temperature area whose temperature is lower than the set temperature to perform a heat dissipation operation.

Alternatively, the abovementioned method further comprises: repeating the heat absorption operation and the heat dissipation operation, until both the inner and surface temperatures of the mobile terminal are lower than the set temperature.

Alternatively, said controlling liquid metal pre-positioned within a mobile terminal to flow to a high-temperature area whose temperature exceeds a set temperature to perform a heat absorption operation when an inner or surface temperature of the mobile terminal exceeds the set temperature, comprises:

detecting a temperature of each area inner the mobile terminal or on the surface of the mobile terminal in real time, when the temperature of one or more areas exceeds a first set temperature, controlling the liquid metal to flow from an initial area within the mobile terminal to a high-temperature area whose temperature exceeds the first set temperature to perform the heat absorption operation.

Alternatively, said controlling the heat-absorbed liquid metal to flow to a non-high-temperature area whose temperature is lower than the set temperature to perform a heat dissipation operation, comprises:

when the temperature of the heat-absorbed liquid metal arises to a second set temperature, controlling the liquid metal to flow from the high-temperature area to a non-high-temperature area whose temperature is lower than the first set temperature to perform a heat dissipation operation.

Alternatively, said repeating the heat absorbing operation and the heat dissipation operation comprises:

after controlling the liquid metal to flow to the determined non-high-temperature area to perform the heat dissipation operation, and when the temperature of the heat-dissipated liquid metal reduces to a third set temperature, controlling the liquid metal to flow to a high-temperature area whose temperature exceeds the first set temperature for a new round of heat absorption operation and heat dissipation operation.

Alternatively, the liquid metal is encapsulated in the initial area of the mobile terminal in a form of film or foil.

Alternatively, the liquid metal adopts a gallium indium alloy whose mass percentage is 75% gallium and 25% indium.

The embodiment of the present invention further provides a mobile terminal, comprising: liquid metal and a control unit, wherein:

the liquid metal is pre-positioned in the mobile terminal; and

the control unit is configured to: when an inner or surface temperature of the mobile terminal exceeds a set temperature, control the liquid metal to flow to a high-temperature area whose temperature exceeds the set temperature to perform a heat absorption operation, and control the heat-absorbed liquid metal to flow to a non-high-temperature area whose temperature is lower than the set temperature to perform a heat dissipation operation.

Alternatively, the control unit is further configured to: control the liquid metal to repeat the heat absorption operation and the heat dissipation operation until both the inner and surface temperatures of the mobile terminal are lower than the set temperature.

Alternatively, the liquid metal is encapsulated in an initial region of the mobile terminal in a form of film or foil.

Alternatively, the liquid metal adopts a gallium indium alloy whose mass percentage is 75% gallium and 25% indium.

The technical solution of the present application effectively solves the heat dissipation problem of components such as battery and chips that generate heat in a high-performance mobile terminal device. Using the technical solution of the present application also provides a new direction and idea for the mobile terminal development.

Brief Description of the Drawings

FIG. 1 is a flow chart of a liquid metal heat dissipation method of a mobile terminal in accordance with a first embodiment of the present invention;

FIG. 2 is a schematic block diagram of a mobile terminal in accordance with a second embodiment of the present invention;

FIG. 3a and FIG. 3b are schematic diagrams of a layout of the liquid metal heat dissipation method applied to a motherboard and a battery compartment area of a terminal (such as a mobile phone) in accordance with an embodiment of the present invention;

FIG. 4 is a schematic diagram of the liquid metal heat dissipation method applied to a back cover area of the terminal (such as a mobile phone) in accordance with an embodiment of the present invention;

FIG. 5 is a schematic diagram of a baseboard and a micro-cell unit in accordance with an embodiment of the present invention;

FIG. 6 is a schematic diagram of a liquid metal flow in accordance with an embodiment of the present invention;

FIG. 7 is a flow chart of the liquid metal heat dissipation process of a mobile terminal device proposed in an application example of the present invention.

Preferred Embodiments of the Invention

Hereinafter in conjunction with the accompanying drawings, the technical solution according to the embodiments of the present invention will be described in detail. It should be noted that in the case of no conflict, embodiments and features in the embodiments of the present application may be combined randomly with each other.

The first embodiment

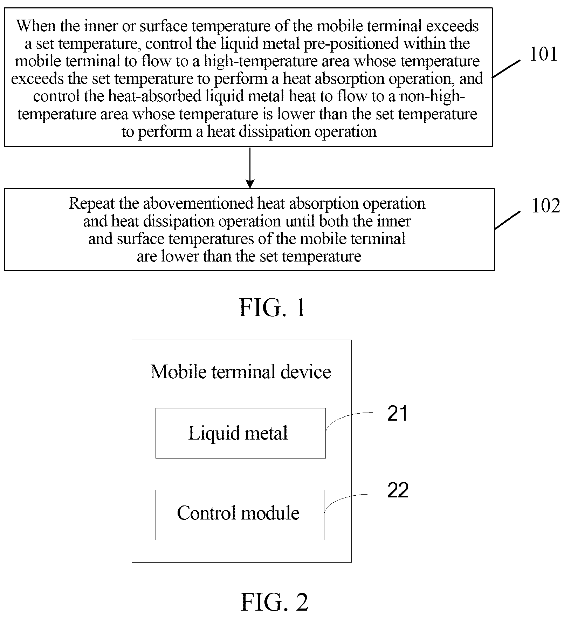

The present embodiment provides a liquid metal heat dissipation method for a mobile terminal, as shown in FIG. 1, the method comprises the following steps:

in step 101, when the inner or surface temperature of the mobile terminal exceeds a set temperature, it is to control the liquid metal pre-positioned within the mobile terminal to flow to a high-temperature area whose temperature exceeds the set temperature to perform a heat absorption operation, and control the heat-absorbed liquid metal to flow to a non-high-temperature area whose temperature is lower than the set temperature to perform a heat dissipation operation.

Wherein, the liquid metal pre-positioned in the mobile terminal has features such as good thermal conductivity, low surface tension, and being liquid at room temperature, it may be encapsulated in the initial area of the mobile terminal in the form of film or foil. The liquid metal can adopt the gallium indium alloy (its mass percentage is 75% gallium and 25% indium).

In step 102, it is to repeat the abovementioned heat absorption operation and heat dissipation operation until both the inner and surface temperatures of the mobile terminal are lower than the set temperature.

In this case, the process comprises the following operations:

detecting the temperature of each area in the inner of the mobile terminal and on the surface of the mobile terminal in real time;

when the temperature of one or more regions exceeds the first set temperature, determining high-temperature areas and non-high-temperature areas of the mobile terminal; and

controlling the liquid metal to flow from the initial area to the determined high-temperature area to perform a heat absorption operation, when the temperature of the liquid metal in the high-temperature area arises, then controlling the liquid metal to flow to the determined non-high-temperature area to dissipate heat, repeating the heat absorption and heat dissipation operations until the temperatures of all areas of the mobile terminal decrease below the first set value, and controlling the liquid metal to flow to the initial area.

Wherein, after the liquid metal absorbs heat in the high-temperature area, it may control the liquid metal to flow to the determined non-high-temperature area to perform a heat dissipation operation when the temperature of the liquid metal arises to a second set temperature.

When the temperature of the heat-dissipated liquid metal decreases to a third set temperature, it may again control the liquid metal to flow to the high-temperature area for a next round of heat absorption and heat dissipation operations.

It also needs to be noted that, after detecting the temperature of each area in the inner of the mobile terminal and on the surface of the mobile terminal in real time, it can determine the low-temperature area in the non-high-temperature areas of the mobile terminal, therefore, during the heat dissipation operation, it can control the liquid metal to flow to the determined low-temperature area to improve the heat dissipation efficiency.

The second embodiment

The present embodiment provides a mobile terminal, and as shown in FIG. 2, the mobile terminal comprises at least liquid metal 21 and a control unit 22. In the following, the working principle of each part will be described.

The liquid metal 21 is pre-positioned in the mobile terminal;

it should be noted that the selected liquid metal has features such as good thermal conductivity, low surface tension, and being liquid at room temperature, the liquid metal may adopt gallium indium alloy (its mass percentage is 75% gallium and 25% indium).

The control unit 22 is used to: when the inner or surface temperature of the mobile terminal exceeds the set temperature, control the abovementioned liquid metal to flow to a high-temperature area whose temperature exceeds the set temperature to perform the heat absorption operation, and control the heat-absorbed liquid metal to flow to a non-high-temperature area whose temperature is lower than the set temperature to perform the heat dissipation operation.

Wherein, the abovementioned control unit 22 may control the liquid metal 21 to repeat the heat absorption operation and the heat dissipation operation until both the inner and surface temperatures of the mobile terminal are lower than the set temperature.

Based on the structure of the abovementioned mobile terminal, the preferred embodiment proposes a mobile terminal, in which a temperature detection unit is added.

The temperature detection unit may be provided on the motherboard of the mobile terminal, or inside or at the surface of the structural component, or the shield component of the mobile terminal, a plurality of temperature sensors are provided in key high-temperature detection areas and other non-high-temperature areas for easily detecting the temperature of each area inside and at the surface of the terminal device;

after the liquid metal is encapsulated in the form of film or foil (there are a variety of ways for encapsulating the liquid metal, which is related to the modeling form of the mobile terminal, and is not limited to this) and works with the control unit, the liquid metal heat dissipation foil (film) covers the heating areas such as the system motherboard and the structural component of the mobile terminal (i.e, the initial area where the liquid metal is located in the mobile terminal); and

when the control unit detects that the heating temperature of a certain area or some areas of the terminal is too high (a red-line temperature value can be set according to the actual situation of the mobile terminal), and the temperature detection system gives a warning when the set red line temperature (i.e., the first set temperature) is exceeded, and notifies the control unit to start working, and reports the coordinate range of the high-temperature area and non-high-temperature area so that the control unit controls the liquid metal to flow to the area with the high temperature (i.e, the high-temperature area), and when the temperature of the liquid metal in the high-temperature area arises, controls the liquid metal to flow to the low-temperature area to be cooled down to dissipate heat. Wherein, the low-temperature area is selected from the non-high-temperature areas except the high-temperature areas, therefore, for the liquid metal that needs to be cooled down to dissipate heat, the temperature of the low-temperature area is lower than the temperatures of other areas and is more suitable for cooling.

Due to the high thermal conductivity and mobility of the metal, it is able to quickly achieve the cooling purpose, the above operations can be cycled until the temperature is normal, and then the control unit stops working. As it can be seen, the preferred embodiment has the temperature detection function that works with the control unit to achieve the function of adaptively and intelligently going to the hot area to cool it down.

Application example

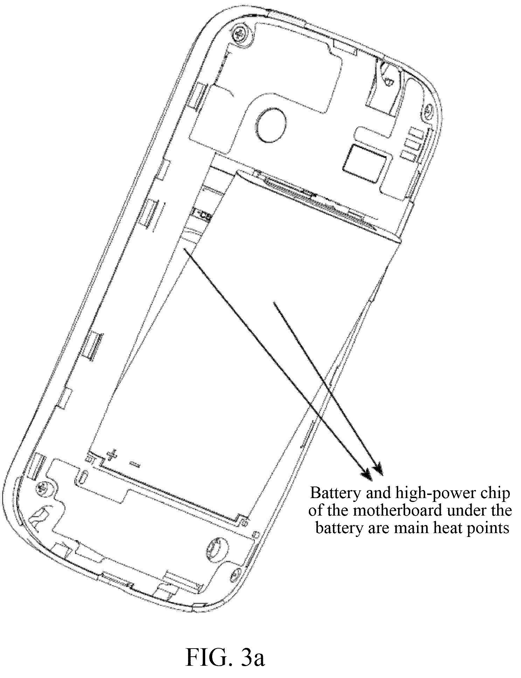

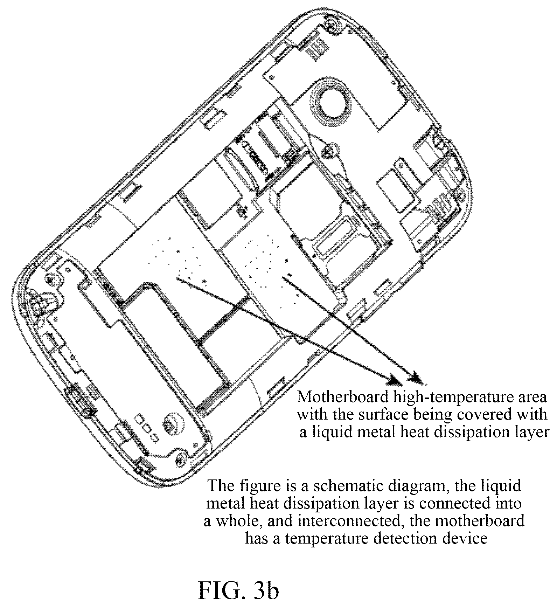

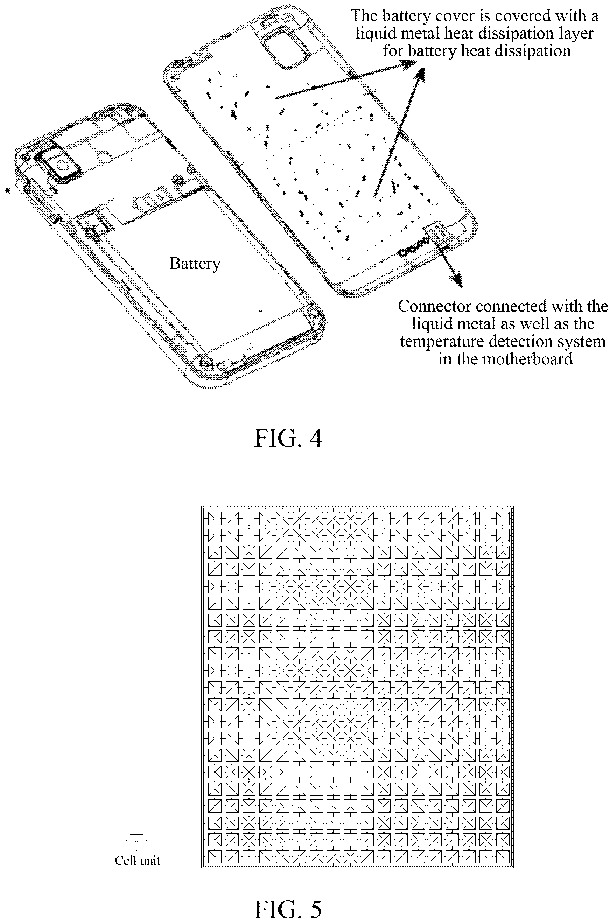

In practical applications, the liquid metal in the abovementioned mobile terminal needs to constitute a liquid metal heat dissipation foil (film) with a flexible material substrate. Wherein, the flexible material substrate (which may be the polydimethylsiloxane substrate) may also have features such as being stretchable, bendable and deformable, and is easy to be made into a conformal body with the structural component of the mobile phone, as shown in FIG. 3a, FIG. 3b and FIG. 4, while the liquid antennas are respectively used in the motherboard surface and back cover areas of the mobile terminal (taking the mobile phone as an example).

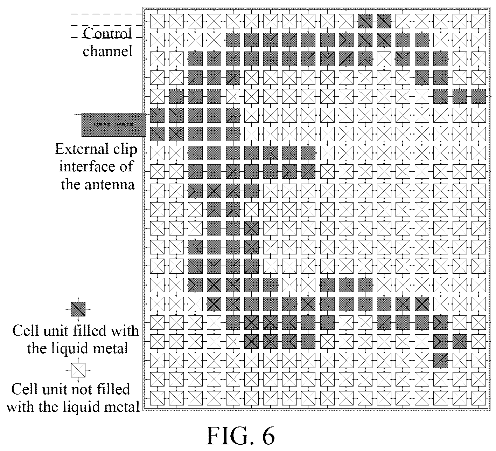

Wherein, the microcell unit of the rectangular polydimethylsiloxane substrate is shown in FIG. 5, its inner part is etched to M*N microcell units, and the respective cell units are interconnected through micropores, forming a M-rows and N-columns microfluidic channel. The liquid metal gallium indium alloy can flow freely in the microfluidic channel or flow under the control of the control device to form a random or fixed shape by filling the corresponding cell units. As shown in FIG. 6, the liquid metal fills in the microcell units within the substrate in accordance with certain rules, to form a liquid heat dissipation effective area with a specific or non-specific shape.

The state of each microcell unit is divided into filling and not-filling, respectively represented with 1 and 0 in the controller, the states of M * N microcell units form a matrix,
$$C_{MN} = \begin{bmatrix} c_{11}, c_{12}, \cdots c_{1N} \\ c_{21}, c_{22}, \cdots c_{2N} \\ \vdots \quad \vdots \quad \ddots \quad \vdots \\ c_{M1}, c_{M2}, \cdots c_{MN} \end{bmatrix},$$
each element

$c_{mn}$ in the matrix $C_{MN}$ corresponds to the state of the $m^{th}$ row and $n^{th}$ column microcell unit within the substrate, 1 for filling, 0 for not filling. The matrix $C_{MN}$ corresponds to the shape of the liquid metal antenna one by one. The matrix $C_{MN}$ is stored in the control device's memory.

The liquid metal is made be in the flowing form by adjusting the matrix $C_{MN}$, according to the coordinates of the high-temperature area provided by the temperature detection system, the liquid metal controller directs the microcell units to "move" according to the coordinate range, making the liquid metal be in the flowing form and flow to the target area.

After staying in the high-temperature area for a while, the temperature of the liquid metal arises, the temperature detection system also gives low-temperature areas while detecting the high-temperature areas, the liquid metal whose temperature arises will flow to the low-temperature area, and the process cycles to get the effect of cooling and dissipating heat.

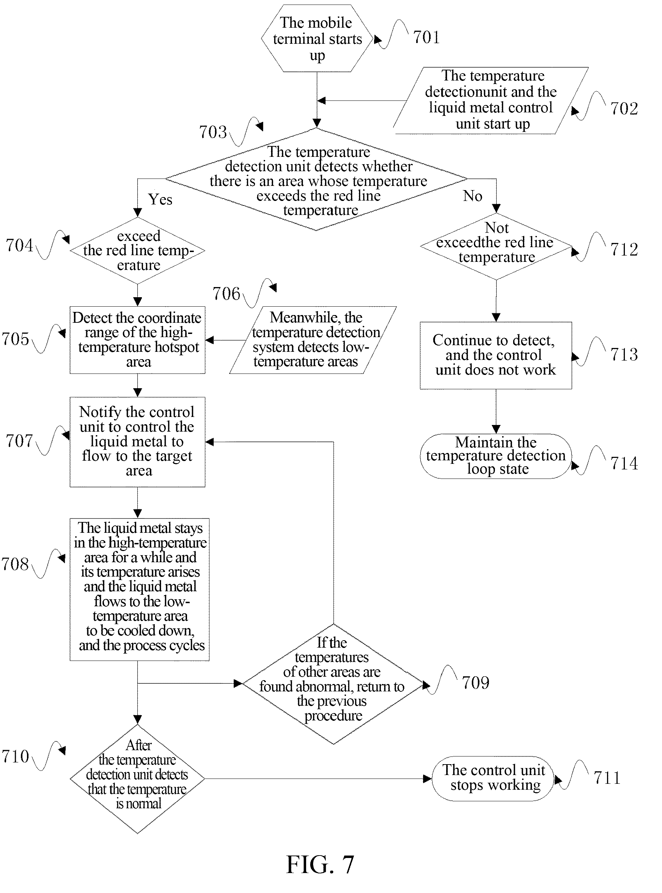

The flow chart of the adaptive intelligent liquid metal heat dissipation process is shown in FIG. 7. This process comprises the following steps:

in step 701, the mobile terminal starts up.

In step 702, the temperature detection unit and the liquid metal control unit start up.

In step 703, the temperature detection unit performs a temperature detection and detects whether there is an area whose temperature exceeds the red line temperature, and if yes, it is to proceed to step 703; otherwise, it is to proceed to step 712.

In step 704, the red line temperature is exceeded.

In step 705, the temperature detection system detects the coordinate range of the high-temperature hotspot area.

In step 706, the temperature detection system detects low-temperature areas.

In step 707, it is to notify the control unit to control the liquid metal to flow to the target area.

In step 708, the liquid metal stays in the high-temperature area for a while and its temperature arises, and the liquid metal flows to the low-temperature area to be cooled down, and the process cycles.

In step 709, if the temperatures of other areas are found abnormal, it is to return to step 707.

In step 710, the temperature detection unit detects that the temperature is normal.

In step 711, the control unit stops working.

In step 712, the red line temperature is not exceeded.

In step 713, the temperature detection unit continues to detect the temperature, at this time, the control unit does not work.

In step 714, it is to maintain the temperature detection loop state.

As can be seen from the above embodiments, compared to the methods currently in use, the technical solution of the present application has the following advantages:

the flowing liquid metal heat dissipation used in the technical solution of the present application can quickly transfer heat to a low-temperature area, its heat dissipation efficiency increases by many times compared to available methods such as graphite fixed conductive heat dissipation, and its effect can be comparable to fan cooling;

The technical solution of the present application can perform an adaptive intelligent firefighting heat dissipation, detect high temperatures and notifies the liquid metal control system to make an instruction through the temperature detection system in the motherboard or accessory structural component and shield component, to make the liquid metal flow to the hot point to absorb heat.

Those ordinarily skilled in the art can understand that all or some of steps of the abovementioned method may be completed by the programs instructing the relevant hardware, and the programs may be stored in a computer-readable storage medium, such as read only memory, magnetic or optical disk. Alternatively, all or some of the steps of the abovementioned embodiments may also be implemented by using one or more integrated circuits. Accordingly, each module/unit in the abovementioned embodiments may be realized in a form of hardware, or in a form of software function modules. The present invention is not limited to any specific form of hardware and software combinations.

The above description is only preferred embodiments of the present invention and is not used to limit the protection scope of the present invention. Any changes, equivalent replacements and improvements made within the spirit and principle of the present application should be included within the protection scope of the present application.

Industrial Applicability

The technical solution of the present application effectively solves the heat dissipation problem of components such as battery and chips that generate heat in a high-performance mobile terminal device; also provides a new direction and idea for the mobile terminal development.

## Claims

1. A liquid metal heat dissipation method of a mobile terminal, comprising:

controlling liquid metal pre-positioned within a mobile terminal to flow to a high-temperature area whose temperature exceeds a set temperature to perform a heat absorption operation when an inner or surface temperature of the mobile terminal exceeds the set temperature, controlling the heat-absorbed liquid metal to flow to a non-high-temperature area whose temperature is lower than the set temperature to perform a heat dissipation operation.

2. The method of claim 1, further comprising:

repeating the heat absorption operation and the heat dissipation operation, until both the inner and surface temperatures of the mobile terminal are lower than the set temperature.

3. The method of claim 1 or 2, wherein, said controlling liquid metal pre-positioned within a mobile terminal to flow to a high-temperature area whose temperature exceeds a set temperature to perform a heat absorption operation when an inner or surface temperature of the mobile terminal exceeds the set temperature, comprises:

detecting a temperature of each area inner the mobile terminal or on the surface of the mobile terminal in real time, when the temperature of one or more areas exceeds a first set temperature, controlling the liquid metal to flow from an initial area within the mobile terminal to a high-temperature area whose temperature exceeds the first set temperature to perform the heat absorption operation.

4. The method of claim 3, wherein, said controlling the heat-absorbed liquid metal to flow to a non-high-temperature area whose temperature is lower than the set temperature to perform a heat dissipation operation, comprises:

when the temperature of the heat-absorbed liquid metal arises to a second set temperature, controlling the liquid metal to flow from the high-temperature area to a non-high-temperature area whose temperature is lower than the first set temperature to perform the heat dissipation operation.

5. The method of claim 4, wherein, said repeating the heat absorbing operation and the heat dissipation operation comprises:

after controlling the liquid metal to flow to the determined non-high-temperature area to perform the heat dissipation operation, and when the temperature of the heat-dissipated liquid metal reduces to a third set temperature, controlling the liquid metal to flow to a high-temperature area whose temperature exceeds the first set temperature for a new round of heat absorption operation and heat dissipation operation.

6. The method of claim 3, wherein, the liquid metal is encapsulated in the initial area of the mobile terminal in a form of film or foil.

7. The method of claim 6, wherein, the liquid metal adopts a gallium indium alloy whose mass percentage is 75% gallium and 25% indium.

8. A mobile terminal, comprising: liquid metal and a control unit, wherein:

   the liquid metal is pre-positioned in the mobile terminal; and
   the control unit is configured to: when an inner or surface temperature of the mobile terminal exceeds a set temperature, control the liquid metal to flow to a high-temperature area whose temperature exceeds the set temperature to perform a heat absorption operation, and control the heat-absorbed liquid metal to flow to a non-high-temperature area whose temperature is lower than the set temperature to perform a heat dissipation operation.

9. The mobile terminal of claim 8, wherein, the control unit is further configured to: control the liquid metal to repeat the heat absorption operation and the heat dissipation operation until both the inner and surface temperatures of the mobile terminal are lower than the set temperature.

10. The mobile terminal of claim 8 or 9, wherein, the liquid metal is encapsulated in an initial region of the mobile terminal in a form of film or foil.

11. The mobile terminal of claim 10, wherein, the liquid metal adopts a gallium indium alloy whose mass percentage is 75% gallium and 25% indium.

When the inner or surface temperature of the mobile terminal exceeds
a set temperature, control the liquid metal pre-positioned within the
mobile terminal to flow to a high-temperature area whose temperature
exceeds the set temperature to perform a heat absorption operation, and
control the heat-absorbed liquid metal heat to flow to a non-high-
temperature area whose temperature is lower than the set temperature
to perform a heat dissipation operation

101

Repeat the abovementioned heat absorption operation
and heat dissipation operation until both the inner
and surface temperatures of the mobile terminal
are lower than the set temperature

102

FIG. 1

Mobile terminal device

Liquid metal

21

Control module

22

FIG. 2

Battery and high-power chip
of the motherboard under the
battery are main heat points

FIG. 3a

Motherboard high-temperature area with the surface being covered with a liquid metal heat dissipation layer

The figure is a schematic diagram, the liquid metal heat dissipation layer is connected into a whole, and interconnected, the motherboard has a temperature detection device

FIG. 3b

The battery cover is covered with a liquid metal heat dissipation layer for battery heat dissipation

Battery

Connector connected with the liquid metal as well as the temperature detection system in the motherboard

FIG. 4

Cell unit

FIG. 5

Control channel

External clip interface of the antenna

Cell unit filled with the liquid metal

Cell unit not filled with the liquid metal

FIG. 6

The mobile terminal starts up — 701

The temperature detectionunit and the liquid metal control unit start up — 702

703 — The temperature detection unit detects whether there is an area whose temperature exceeds the red line temperature

Yes

No

704 — exceed the red line temperature

Not exceedthe red line temperature — 712

706 — Meanwhile, the temperature detection system detects low-temperature areas

705 — Detect the coordinate range of the high-temperature hotspot area

Continue to detect, and the control unit does not work — 713

707 — Notify the control unit to control the liquid metal to flow to the target area

Maintain the temperature detection loop state — 714

708 — The liquid metal stays in the high-temperature area for a while and its temperature arises and the liquid metal flows to the low-temperature area to be cooled down, and the process cycles

709 — If the temperatures of other areas are found abnormal, return to the previous procedure

710 — After the temperature detection unit detects that the temperature is normal

The control unit stops working — 711

FIG. 7

# INTERNATIONAL SEARCH REPORT

| International application No. |
| --- |
| PCT/CN2013/086270 |

## A. CLASSIFICATION OF SUBJECT MATTER

H04M 1/02 (2006.01) i

According to International Patent Classification (IPC) or to both national classification and IPC

## B. FIELDS SEARCHED

Minimum documentation searched (classification system followed by classification symbols)

H04M, H04W, H05K

Documentation searched other than minimum documentation to the extent that such documents are included in the fields searched

Electronic data base consulted during the international search (name of data base and, where practicable, search terms used)

CNPAT, WPI, EPODOC, GOOGLE: Mobie, mobile, portable, cell phone, cell, phone, terminal, PDA, heat, radiat+, conduct+, temperature, liquid, metal, gallium, indium, absorb+, flow+, cool+

## C. DOCUMENTS CONSIDERED TO BE RELEVANT

| Category* | Citation of document, with indication, where appropriate, of the relevant passages | Relevant to claim No. |
| --- | --- | --- |
| X | CN 102377847 A (CHINESE ACAD TECH INST PHYSICS) 14 March 2012 (14.03.2012) description, paragraphs [0015], and [0048]-[0067], and figures 1 and 3 | 1-11 |
| A | CN 102748971 A (CHINESE ACAD TECH INST PHYSICS) 24 October 2012 (24.10.2012) the whole document | 1-11 |
| A | CN 102478930 A (CHINESE ACAD TECH INST PHYSICS CHINESE ACAD TECH INST PHYSICS) 30 May 2012 (30.05.2012) the whole document | 1-11 |
| A | CN 201119148Y (XIE, Xianhuang et al.) 17 September 2008 (17.09.2008) the whole document | 1-11 |

| ☐ Further documents are listed in the continuation of Box C. | ☒ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 04 May 2014 | 30 May 2014 |

| Name and mailing address of the ISA State Intellectual Property Office of the P. R. China No. 6, Xitucheng Road, Jimenqiao Haidian District, Beijing 100088, China Facsimile No. (86-10) 62019451 | Authorized officer SUN, Jie Telephone No. (86-10) 62413840 |
| --- | --- |

Form PCT/ISA /210 (second sheet) (July 2009)

**INTERNATIONAL SEARCH REPORT**
Information on patent family members

| International application No. |
|---|
| PCT/CN2013/086270 |

| Patent Documents referred in the Report | Publication Date | Patent Family | Publication Date |
|---|---|---|---|
| CN 102377847 A | 14 March 2012 | None | |
| CN 102748971 A | 24 October 2012 | None | |
| CN 102478930 A | 30 May 2012 | None | |
| CN 201119148 Y | 17 September 2008 | None | |

Form PCT/ISA /210 (patent family annex) (July 2009)